# FASCICULE DE BREVET EUROPEEN

(11) **EP 1 424 778 B1**
(45) Date de publication et mention de la délivrance du brevet: **30.09.2009**
(21) Numéro de dépôt: 03104422.5
(22) Date de dépôt: 27.11.2003
(51) Int. Cl.: H03L 7/16

(54) **Dispositif et procédé de synthèse de fréquence à grande pureté spectrale**
Vorrichtung und dazugehöriges Verfahren zur Erzeugung einer Frequenz mit hoher spektraler Reinheit
Device and method for frequency synthesis with high spectral purity

(30) Priorité: 29.11.2002 FR 0215066
(43) Date de publication de la demande: 02.06.2004
(73) Titulaire: Thales, 92200 Neuilly Sur Seine (FR)
(72) Inventeur: GABET, Pascal, 94117 CX, ARCUEIL (FR); DE GOUY, Jean-Luc, 94117 CX, ARCUEIL (FR)
(74) Mandataire: Dudouit, Isabelle

(56) Documents cités:
- EP-A- 0 278 140
- EP-A- 0 419 823
- US-A- 5 128 633
- US-B1- 6 239 660

## Description

La présente invention concerne un dispositif et un procédé de synthèse à grande pureté spectrale.

Elle concerne notamment la division variable d'un synthétiseur à pas variable permettant d'obtenir une grande pureté spectrale et un pas de fréquence constant.

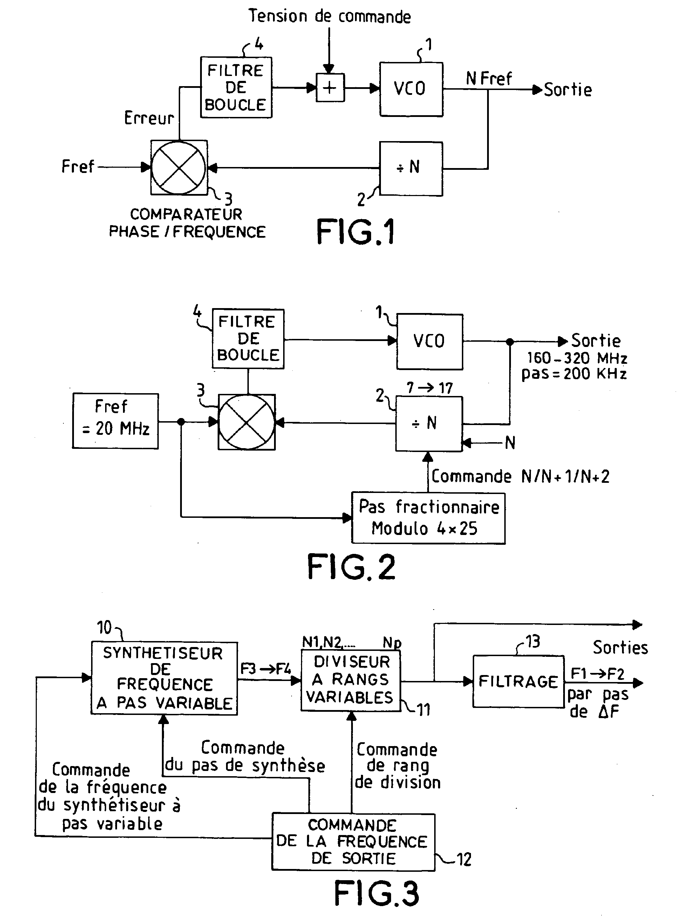

Le schéma de principe d'une boucle à verrouillage de phase est donné à la figure 1. La boucle comprend un oscillateur commandé en tension 1 (VCO - Voltage Controlled Oscillateur) dont on souhaite asservir la phase sur celle d'un signal de référence Fref. Pour cela, la sortie du VCO est divisée par un diviseur de fréquence 2 et le VCO divisé est comparé à la fréquence de référence Fref grâce à un comparateur phase/fréquence 3. Le signal d'erreur issu du comparateur est ensuite filtré par le filtre de boucle 4 qui détermine la stabilité de l'asservissement. Le VCO est commandé par une tension de commande à laquelle le signal filtré est superposé. Lorsque le VCO est asservi en phase, la fréquence de sortie est égale à N*Fref où N est le rang du diviseur. En faisant varier N de N1 à N2, (N2>N1) par pas de 1, le VCO excursionne au pas de Fref une bande de fréquence correspondant à (N2-N1)*Fref.

Lorsque l'on veut générer des pas de fréquence plus fins que Fref il est possible de baisser la valeur de Fref mais cela a pour conséquence d'augmenter la valeur des rangs de division et donc d'augmenter le bruit de phase du synthétiseur.

La technique appelée synthèse à pas fractionnaire permet de résoudre ce problème. Elle est illustrée à la figure 2 par le schéma synoptique d'un synthétiseur 160-320 MHz.

Elle consiste à faire varier dynamiquement le rang de division N de façon à générer par exemple un N moyen comportant une partie fractionnaire. Par exemple, si une fois sur dix on divise par N+1 au lieu de N, le N moyen est égal à (N+1)/10. Le rythme de variation de N étant très supérieur à la bande de boucle de l'asservissement, le VCO se décale de 1/10 de la fréquence Fref. II s'en suit une variation de phase de 2π/N au niveau du comparateur phase/fréquence. Cette technique engendre des raies parasites au niveau de la sortie du VCO. Pour un triple pas fractionnaire, qui permet de diminuer le niveau de ces raies parasites, cette variation passe à 6π/N.

Il est nécessaire de maintenir cette variation au dessous de 120° surtout si on utilise un comparateur de phase de type mélangeur à diodes associé à un dispositif de recherche en fréquence. Ceci conduit à utiliser des rangs de division minimum égaux à environ 10.

Le synthétiseur comporte un VCO couvrant la bande de fréquence 160-320 MHz. Le VCO divisé par N est comparé à une fréquence de référence de 20 MHz. Un signal de commande N/N+1/N+2 effectue au rythme de 20 MHz, les variations du rang de division N de façon à générer des pas au centième de la valeur de la fréquence de référence (on utilise un double pas fractionnaire avec 2 modulo égaux à 4 et 25 de façon à bénéficier d'une atténuation supplémentaire sur les 3 premières raies fractionnaires).

Cette méthode présente toutefois les inconvénients suivants :
1) le VCO doit couvrir une bande d'un octave, ce qui rend sa réalisation délicate,
2) le diviseur N couvre lui aussi l'octave, ce qui induit une variation de 2 du gain de boucle de l'asservissement, laquelle variation se combine aux variations possibles de pentes du VCO et conduit à une complexité accrue, du fait qu'il faut compenser ces variations pour maintenir le temps de commutation et le niveau des raies parasites dans toute la gamme de fréquences,
3) le temps de commutation du synthétiseur est limité car la bande de boucle de l'asservissement doit être inférieure à la valeur de la première raie fractionnaire (200 KHz dans l'exemple donné) pour pouvoir bénéficier d'une atténuation supplémentaire de cette raie par la fonction de transfert de la boucle de phase,
4) le rang de division minimum étant voisin de 10 et le diviseur devant couvrir l'octave, il en découle une augmentation d'au moins 26 dB du bruit de phase par rapport au bruit technologique des diviseurs.

La demande de brevet EP 0 278 140 divulgue un générateur de signal d'horloge comprenant un diviseur ajustable pour ajuster le débit de signal d'horloge en sortie de boucle.

Le brevet US 6 239 660 décrit une méthode de contrôle d'un synthétiseur de fréquence qui comprend un synthétiseur numérique dont la sortie signal est couplée à l'entrée d'une boucle de phase. Le synthétiseur numérique comprend un circuit de contrôle pour controler la fréquence du synthétiseur d'une première fréquence à une deuxième fréquence en accord avec des étapes de fréquence prédéterminées.

L'invention concerne un procédé et un dispositif permettant notamment de s'affranchir des inconvénients de l'art antérieur.

L'invention concerne un dispositif pour synthétiser un signal dans une première bande de fréquences F1 - F2 comprenant :
- un synthétiseur de fréquence à boucle à verrouillage de phase comprenant un diviseur de boucle de rang Na pour générer un signal dans une deuxième bande de fréquence F3-F4,
- un diviseur pour diviser la fréquence du signal de sortie dudit synthétiseur par un rang variable Nb,
- un dispositif de contrôle de fréquence pour contrôler les rangs de division Na et Nb,
**caractérisé en ce que**
- ledit synthétiseur est de type fractionnaire, le rang de division Na variant de manière cyclique,
- la longueur du cycle de variation de Na varie en fonction de Nb.

Nb prend les valeurs de la suite N1 à Np, ces dernières suivant une progression arithmétique ou une progression non arithmétique.
Le dispositif peut comporter un dispositif de filtrage disposé après le diviseur divisant la fréquence du sigal de sortie dudit synthétiseur par un rang variable Nb.
Le dispositif peut comporter un mélangeur recevant le signal de sortie du synthétiseur à pas fractionnaire et un signal de mélange.

L'invention concerne aussi un procédé pour synthétiser un signal dans une première bande de fréquence F1-F2 comprenant les étapes suivantes :
- synthétiser un signal dans une deuxième bande de fréquence F3-F4 à l'aide d'un synthétiseur de fréquence à boucle de verrouillage de phase comprenant un diviseur de boucle à rang variable Na(2),
- diviser la fréquence du signal de sortie dudit synthétiseur par un rang variable Nb,
- contrôler les rangs de division Na et Nb,
**caractérisé en ce que**
- la synthèse du signal dans une deuxième bande de fréquence est une synthèse à pas fractionnaire, le rang de division Na variant de manière cyclique,
- la longueur du cycle de variation de Na varie en fonction de Nb.

L'invention offre notamment les avantages suivants :
- Elle permet d'augmenter les performances d'un synthétiseur à pas fractionnaire tout en étant simple,
- Un gain notable en diminuant la bande relative du VCO,
- Une amélioration de la qualité spectrale,
- Une augmentation de la vitesse de commutation du synthétiseur.

D'autres caractéristiques et avantages de l'invention apparaîtront mieux à la lecture de la description qui suit d'un exemple détaillé donné à titre illustratif et nullement limitatif annexé des figures qui représentent :
- La figure 1 un schéma de principe du fonctionnement d'un synthétiseur à pas fractionnaire,
- La figure 2 un schéma synoptique d'un synthétiseur à pas fractionnaire selon l'art antérieur,
- La figure 3 un schéma synoptique d'un exemple de dispositif selon l'invention,
- Les figures 4 et 5 deux variantes de réalisation du dispositif de la figure 3,
- La figure 6 un exemple chiffré.

Afin de mieux faire comprendre l'objet de la présente invention, l'exemple qui suit donné à titre illustratif et nullement limitatif concerne un synthétiseur de fréquence 160 - 320 MHz.

Les références se retrouvant dans les figures 2, 3, 4 et 5 désignent des éléments semblables.

La figure 3 décrit un exemple de dispositif selon l'invention comportant par exemple un synthétiseur 10 de fréquence à pas variable qui délivre un signal dont la fréquence fondamentale est comprise entre une fréquence F3 et une fréquence F4. II comprend un diviseur 11 à rang variable Nb qui prend les valeurs N1 à Np (avec N1<N2...<Np), un dispositif de commande 12 de la fréquence de sortie et éventuellement un filtre 13.

Le dispositif de commande 12 délivre les commandes suivantes :
- La commande du rang Nb du diviseur à rang variable,
- La commande de la fréquence du synthétiseur à pas variable qui varie de F3 à F4,
- La commande du pas de synthèse de fréquence à pas variable.

Ces trois commandes sont, par exemple en fonctionnement normal, mises en oeuvre simultanément.

La valeur la plus petite du rang de division Nb est choisie par exemple égale à N1. Cette valeur N1 détermine l'amélioration souhaitée des qualités spectrales du synthétiseur à pas variable en terme de bruit de phase et de raies parasites. La plus petite valeur N1 est choisie par exemple en fonction du gabarit du bruit de phase souhaité en sortie globale et du gabarit du bruit de phase possible pour le synthétiseur situé en amont du diviseur. En effet, le fait de diviser par le rang de division Nb, dont la plus petite valeur est N1, va améliorer d'au moins 20log(N1) dB le bruit de phase du synthétiseur à pas variable.

La fréquence maximale du synthétiseur à pas variable est alors donnée par F4=N1*F2, F2 étant la fréquence maximale de sortie du dispositif selon l'invention.

Dans le cas où la suite N1...Np est choisie en progression arithmétique, la fréquence minimale du synthétiseur à pas variable est donnée par N2. On choisit par exemple F3 sensiblement égale à (N1/N2)*F4 ou légèrement inférieure.

Dans le cas où les valeurs de la suite N1.....Np ne suivent pas une progression arithmétique, on compare les différents rapports obtenus en divisant deux éléments consécutifs de la suite, soit N1/N2, N2/N3, ..., (Np-1 )/Np. Soit a la plus petite valeur de ces rapports; on choisit par exemple F3 sensiblement égal ou inférieur à aF4 ou la valeur la plus proche et légèrement inférieure.

Ainsi, le fait de faire varier le rang Nb du diviseur permet de couvrir de façon continue la bande F1 → F2 de sortie en ne disposant que d'un synthétiseur de bande relative réduite (F3 → F4).

Les différents rapports N1/N2, N2/N3, ..., (Np-1)/Np ne sont pas égaux en règle générale. Donc, les plages de fréquences obtenues à partir de F3 → F4 en effectuant les divisions par N1, N2, ... Np, soit F3/N1 → F4/N1, F3/N2 → F4/N2 , ..... , F3/Np → F4/Np se chevauchent partiellement, c'est à dire que certaines fréquences de sortie peuvent être obtenues à partir de deux rangs de division Nb différents. Dans ce cas, pour maximiser les performances spectrales du dispositif, on choisira par exemple le rang de division Nb le plus élevé.

Pour obtenir la bande de fréquence de sortie F1 → F2 avec un pas de fréquence ΔF constant, le procédé modifie le rang de division Nb et également le pas de synthèse du synthétiseur à pas variable. C'est à dire :
- lorsque l'on divise par N1, le pas de synthèse du synthétiseur à pas variable doit être N1ΔF,
- lorsque l'on divise par N2, le pas de synthèse du synthétiseur à pas variable doit être N2ΔF, et ainsi de suite.

Ainsi, la plage de fréquences F1 → F2 est couverte avec un pas de fréquence ΔF constant.

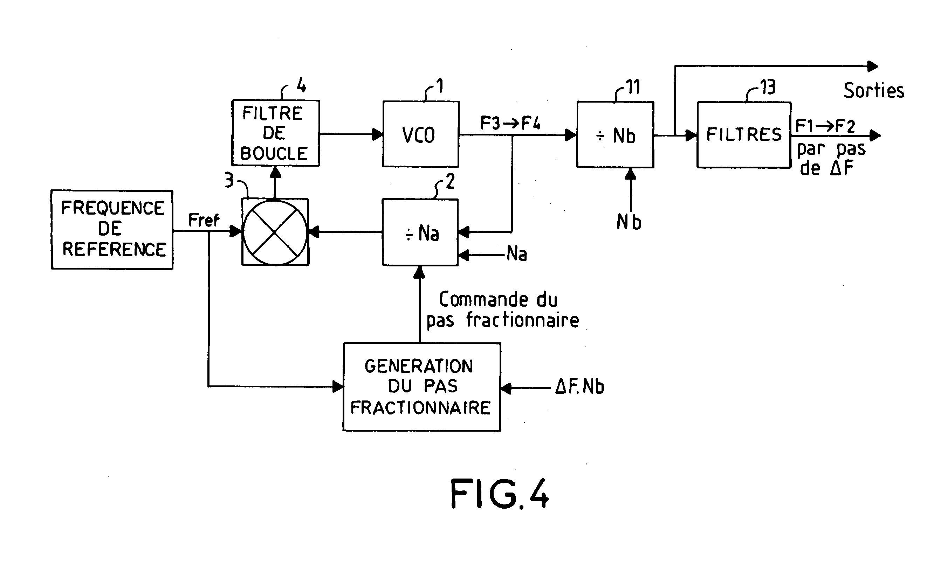

La figure 4 représente un exemple de réalisation du dispositif selon l'invention.

II comprend un synthétiseur fractionnaire ayant une architecture sensiblement identique à celle donnée à la figure 2 et qui ne sera pas détaillée, un diviseur 11 qui divise par Nb variable, suivi d'éléments de filtrage optionnels référencés 13. Le synthétiseur à pas variable est réalisé par exemple par une boucle à verrouillage de phase à pas fractionnaires décrite précédemment.

Le fait de faire travailler ce type de synthétiseur avec des pas variables est dicté par la nécessité d'obtenir des pas de fréquence constants ou sensiblement constants en sortie du diviseur par Nb.

Dans un synthétiseur à pas fractionnaires, le pas de fréquence est une fraction de la fréquence Fref. Par exemple, pour obtenir un pas égal à Fref/5, on fait évoluer le rang de division Na du synthétiseur de fréquence sur un cycle de 5 périodes de Fref.

Dans le dispositif selon l'invention, la longueur du cycle d'évolution de Na est variable et dépend de la valeur Nb (valeur de division du diviseur à rangs variables). La fréquence de référence Fref est choisie afin d'obtenir les pas fractionnaires souhaités de la manière suivante par exemple :
- Fref est fonction de la suite des valeurs N1, N2, ... Np que peut prendre Nb,
- Fref/ΔF doit être un multiple du PPCM de N1, N2, ... Np.

Ainsi, les nombres Fref/N1ΔF, Fref/N2ΔF, ....., Fref/NpΔF sont entiers et définissent les différents modulo à utiliser pour le pas fractionnaire dans les cas respectifs où Nb vaut N1, N2, ... Np.

On parle de modulo car généralement, le pas fractionnaire est implémenté à l'aide d'un ou plusieurs accumulateurs dont la somme des retenues vient commander les variations du diviseur Na.

Par exemple, avec une fréquence de référence de 20 MHz, on réalise des pas de 200 KHz avec un modulo 100, lequel peut être décomposé en deux accumulateurs modulo 4 et modulo 25 de façon à réaliser un double pas fractionnaire.

Le dispositif selon l'invention utilise soit un simple pas fractionnaire soit un multiple pas fractionnaire. Pour cela, le dispositif comporte par exemple un accumulateur ou plusieurs accumulateurs qui seront programmables en modulo de façon à réaliser les pas variables nécessaires pour le procédé selon l'invention.

II est bien évident que tout dispositif permettant de réaliser une commande cyclique du rang de division Na avec la possibilité de programmer la longueur de ce cycle peut convenir.

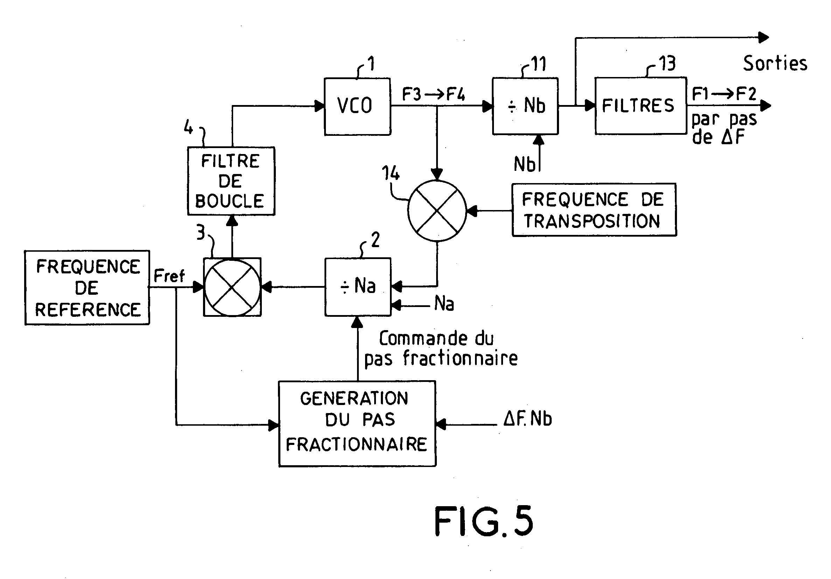

La figure 5 représente une variante de réalisation du dispositif de la figure 4.

Cette variante consiste à inclure une étape de transposition de fréquence dans la boucle de phase fractionnaire entre le VCO et le diviseur Na. Cette fréquence de transposition est un multiple de ΔF multiplié par le PPCM des valeurs du rang de division Nb. Elle est réalisée en adjoignant au dispositif un mélangeur 14 recevant le signal de sortie du VCO ainsi que la fréquence de transposition. Le signal transposé est ensuite transmis au diviseur 2.

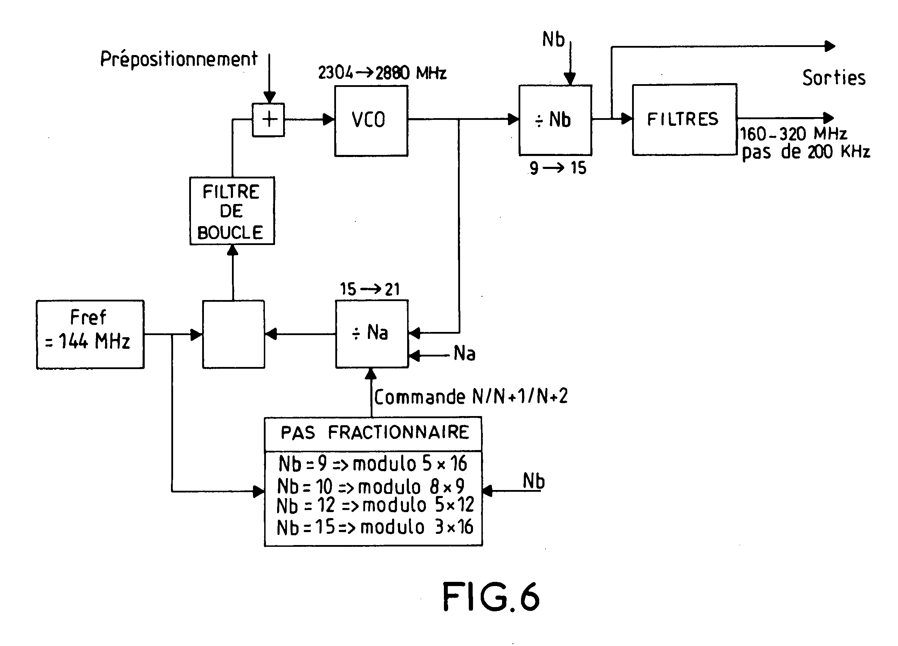

La figure 6 illustre un exemple chiffré pour réaliser un dispositif selon l'invention avec un synthétiseur de fréquence 160-320 MHz.

Dans cet exemple, Nb = 9, 10, 12, 15, et la bande du VCO varie de 2304 à 2880 MHz pour obtenir en continuité la bande de sortie 160 à 320 MHz.

Pour obtenir un pas constant de 200 KHz en sortie, il faut que le synthétiseur fractionnaire puisse générer des pas de 1,8 MHz, 2 MHz, 2,4 MHz, et 3 MHz.

Le PPCM de Nb est égal à 180. Il faut donc que Fref soit multiple de 36 MHz.

On choisit 144 MHz et on en déduit les différents modulo à réaliser; soit 80, 72, 60 et 48.

Ces modulo peuvent être décomposés en 2 pour une réalisation en double pas fractionnaire: 80 = 5x16, 72 = 8x9, 60 = 5x12, 48 = 3x16.

Le tableau 1 suivant résume les performances obtenues avec un synthétiseur selon l'art antérieur.

| **CARACTERISTIQUE** | **PERFORMANCE** |
|---|---|
| Bande relative du VCO (B/Fo) | 67% |
| Augmentation du bruit par rapport à Fref + bruit comparateur | + 20 log (Nmax) = 26 dB |
| Gain sur le bruit de phase du VCO | 0 dB |
| Ecart de fréquence de la raie parasite située en limite de bande de boucle | 200 KHz |
| Atténuation de la première raie parasite située en limite de bande de boucle | 58 dB @ 200 KHz |

Le tableau 2 les résultats obtenus avec la nouvelle méthode et donne le gain sur cet exemple par rapport à l'art antérieur.

| **CARACTERISTIQUE** | **PERFORMANCE** | **GAIN SUR L'ART ANTERIEUR** |
|---|---|---|
| Bande relative du VCO | 22,2% | Bande relative divisée par 3 |
| Augmentation du bruit | + 20 log (Namax/Nbmin) = 6,94 dB | Gain de 19 dB sur le bruit de phase |
| Gain sur le bruit VCO | 20log(Nbmin) | Gain de 19 dB (limité par le bruit de phase plancher de Nb) |
| Ecart de fréquence de la raie parasite la plus proche | 1,8 MHz => possibilité d'une grande bande de boucle | Gain d'un rapport 9 sur la vitesse de commutation |
| Atténuation de la première raie parasite située en limite de bande de boucle | 81 dB @ 1,8 MHz | Meilleure réjection des raies fractionnaires + 23 dB sur la première |

On voit donc que la méthode proposée est simple à mettre en oeuvre et qu'elle apporte un gain notable en:
- diminuant la bande relative du VCO,
- améliorant la qualité spectrale,
- augmentant la vitesse de commutation du synthétiseur.

Sans sortir du cadre de l'invention tout dispositif permettant d'obtenir un pas variable peut être utilisé, par exemple un synthétiseur à pas fractionnaire, etc. ou tout autre dispositif connu de l'Homme du métier.

## Revendications

1. Dispositif pour synthétiser un signal dans une première bande de fréquences F1 - F2 comprenant :
• un synthétiseur de fréquence à boucle à verrouillage de phase comprenant un diviseur de boucle de rang Na(2) pour générer un signal dans une deuxième bande de fréquence F3-F4,
• un diviseur pour diviser la fréquence du signal de sortie dudit synthétiseur par un rang variable Nb,
• un dispositif de contrôle de fréquence pour contrôler les rangs de division Na et Nb,
**caractérisé en ce que**
• ledit synthétiseur est de type fractionnaire, le rang de division Na variant de manière cyclique,
• la longueur du cycle de variation de Na varie en fonction de Nb(11).

2. Dispositif selon la revendication 1, **caractérisé en ce qu'**il comporte un dispositif de filtrage disposé après le diviseur divisant la fréquence du signal de sortie dudit synthétiseur par un rang variable Nb.

3. Dispositif selon l'une des revendications 1 ou 2, **caractérisé en ce que** Nb prend les valeurs N1 à Np, ces dernières suivant une progression arithmétique et **en ce que** la fréquence maximale du synthétiseur est donnée par F4=N1*F2 où N1 est la plus petite valeur de la suite N1 à Np et la fréquence F3 est fonction de N2.

4. Dispositif selon la revendication 3, **caractérisé en ce que** la valeur de la fréquence F3 est sensiblement égale à (N1/N2)*F4 ou légèrement inférieure.

5. Dispositif selon l'une des revendications 1 ou 2, **caractérisé en ce** Nb prend les valeurs de la suite N1 à Np, ces dernières suivant une progression non arithmétique.

6. Dispositif selon la revendication 5, **caractérisé en ce que** F3 est sensiblement égale ou inférieure à aF4 où a est la plus petite valeur obtenue en divisant deux éléments consécutifs de la suite N1, ...Np.

7. Dispositif selon la revendication 5, **caractérisé en ce que** lorsque plusieurs réglages permettent de générer une même fréquence de sortie, le réglage consiste à choisir le rang de division Nb le plus élevé pour générer la fréquence.

8. Dispositif selon la revendication 1 **caractérisé en que** chacune des longueurs du cycle de la commande N/N+1/N+2/. ... correspondant à chaque valeur possible de Nb est le produit de nombres premiers entre eux.

9. Dispositif selon l'une des revendications 1 à 8, **caractérisé en ce qu'**il comporte un mélangeur recevant le signal de sortie du synthétiseur à pas fractionnaire et un signal de mélange.

10. Procédé pour synthétiser un signal dans une première bande de fréquence F1-F2 comprenant les étapes suivantes :
• synthétiser un signal dans une deuxième bande de fréquence F3-F4 à l'aide d'un synthétiseur de fréquence à boucle de verrouillage de phase comprenant un diviseur de boucle à rang variable Na(2),
• diviser la fréquence du signal de sortie dudit synthétiseur par un rang variable Nb,
• contrôler les rangs de division Na et Nb,
**caractérisé en ce que**
• la synthèse du signal dans une deuxième bande de fréquence est une synthèse à pas fractionnaire, le rang de division Na variant de manière cyclique,
• la longueur du cycle de variation de Na varie en fonction de Nb.

11. Procédé selon la revendication 10, **caractérisé en ce que** les valeurs Nb varient selon une suite arithmétique N1...Np et **en ce que** la fréquence F4 est égale à N1*F2 et la fréquence F3 est fonction de N2.

12. Procédé selon la revendication 11, **caractérisé en ce que** l'on choisit la valeur de la fréquence F3 sensiblement égale à (N1/N2)*F4 ou légèrement inférieure.

13. Procédé selon la revendication 10, **caractérisé en ce que** les valeurs Nb varient selon une suite non arithmétique et **en ce que** l'on compare les rapports obtenus en divisant deux éléments consécutifs de la suite N1/N2, .....(Np-1)/Np.

14. Procédé selon la revendication 13, **caractérisé en ce que** F3 est sensiblement égale ou inférieure à aF4 où a est la plus petite valeur obtenue en divisant deux éléments consécutifs de la suite.

15. Procédé selon la revendication 14, **caractérisé en ce que** lorsque plusieurs réglages permettent de générer une même fréquence de sortie, le réglage qui comporte le rang de division Nb le plus élevé est utilisé pour générer la fréquence.

16. Procédé selon l'une des revendications 10 à 15, **caractérisé en ce que** la modification des rangs de division est simultanée.

17. Procédé selon l'une des revendications 10 à 16, **caractérisé en ce que** le rapport entre la fréquence de référence du synthétiseur à pas variable et le pas de fréquence Fref/ΔF est le PPCM de la suite N1...Np.

## Claims

1. Device for synthesizing a signal in a first frequency band F1 - F2 comprising:
• a frequency synthesizer with phase-locked loop comprising a loop divider of rank Na (2) for generating a signal in a second frequency band F3-F4,
• a divider for dividing the frequency of the output signal of said synthesizer by a variable rank Nb,
• a frequency control device for controlling the division ranks Na and Nb,
**characterized in that**
• said synthesizer is of the fractional type, the division rank Na varying in a cyclic manner,
• the length of the cycle of variation of Na varies as a function of Nb(11).

2. Device according to Claim 1, **characterized in that** it comprises a filtering device disposed after the divider dividing the frequency of the output signal of said synthesizer by a variable rank Nb.

3. Device according to one of Claims 1 or 2, **characterized in that** Nb takes the values N1 to Np, these latter following an arithmetic progression and **in that** the maximum frequency of the synthesizer is given by F4=N1*F2 where N1 is the smallest value of the series N1 to Np and the frequency F3 is dependent on N2.

4. Device according to Claim 3, **characterized in that** the value of the frequency F3 is substantially equal to (N1/N2)*F4 or slightly less.

5. Device according to one of Claims 1 or 2, **characterized in that** Nb takes the values of the series N1 to Np, these latter following a non-arithmetic progression.

6. Device according to Claim 5, **characterized in that** F3 is substantially equal to or less than aF4 where a is the smallest value obtained by dividing two consecutive elements of the series N1,...Np.

7. Device according to Claim 5, **characterized in that** when several settings make it possible to generate one and the same output frequency, the setting consists in choosing the highest division rank Nb to generate the frequency.

8. Device according to Claim 1, **characterized in that** each of the lengths of the cycle of the command N/N+1/N+2... corresponding to each possible value of Nb is the product of relatively prime numbers.

9. Device according to one of Claims 1 to 8, **characterized in that** it comprises a mixer receiving the output signal of the fractional-increment synthesizer and a mixture signal.

10. Method for synthesizing a signal in a first frequency band F1-F2 comprising the following steps:
• synthesizing a signal in a second frequency band F3-F4 with the aid of a frequency synthesizer with phase-locked loop comprising a loop divider of variable rank Na(2),
• dividing the frequency of the output signal of said synthesizer by a variable rank Nb,
• controlling the division ranks Na and Nb,
**characterized in that**
• the synthesis of the signal in a second frequency band is a fractional-increment synthesis, the division rank Na varying in a cyclic manner,
• the length of the cycle of variation of Na varies as a function of Nb.

11. Method according to Claim 10, **characterized in that** the values Nb vary according to an arithmetic series N1...Np and **in that** the frequency F4 is equal to N1*F2 and the frequency F3 is dependent on N2.

12. Method according to Claim 11, **characterized in that** the value of the frequency F3 is chosen substantially equal to (N1/N2)*F4 or slightly less.

13. Method according to Claim 10, **characterized in that** the values Nb vary according to a non-arithmetic series and **in that** the ratios obtained by dividing two consecutive elements of the series N1/N2,...(Np-1) /Np are compared.

14. Method according to Claim 13, **characterized in that** F3 is substantially equal to or less than aF4 where a is the smallest value obtained by dividing two consecutive elements of the series.

15. Method according to Claim 14, **characterized in that** when several settings make it possible to generate one and the same output frequency, the setting which comprises the highest division rank Nb is used to generate the frequency.

16. Method according to one of Claims 10 to 15, **characterized in that** the modification of the division ranks is simultaneous.

17. Method according to one of Claims 10 to 16, **characterized in that** the ratio between the reference frequency of the variable-increment synthesizer and the frequency increment Fref/ΔF is the LCM of the series N1...Np.

## Patentansprüche

1. Vorrichtung zum Synthetisieren eines Signals in einem ersten Frequenzband F1-F2, die enthält:
• einen Frequenzsynthetisierer mit Phasenverriegelungsschleife, der einen Schleifenteiler des Rangs Na(2) enthält, um ein Signal in einem zweiten Frequenzband F3-F4 zu erzeugen,
• einen Teiler, um die Frequenz des Ausgangssignals des Synthetisierers durch einen variablen Rang Nb zu teilen,
• eine Frequenzüberwachungsvorrichtung, um die Teilungsränge Na und Nb zu überwachen,
**dadurch gekennzeichnet, dass**
• der Synthetisierer vom Fraktional-Typ ist, wobei der Teilungsrang Na zyklisch variiert,
• die Länge des Variationszyklus von Na in Abhängigkeit von Nb(11) variiert.

2. Vorrichtung nach Anspruch 1, **dadurch gekennzeichnet, dass** sie eine Filtervorrichtung aufweist, die nach dem Teiler angeordnet ist, der die Frequenz des Ausgangssignals des Synthetisierers durch einen variablen Rang Nb teilt.

3. Vorrichtung nach einem der Ansprüche 1 oder 2, **dadurch gekennzeichnet, dass** Nb die Werte N1 bis Np annimmt, wobei letztere einer arithmetischen Progression folgen, und dass die maximale Frequenz des Synthetisierers durch F4 = N1*F2 gegeben wird, wobei N1 der kleinste Wert der Folge N1 bis Np und die Frequenz F3 eine Funktion von N2 ist.

4. Vorrichtung nach Anspruch 3, **dadurch gekennzeichnet, dass** der Wert der Frequenz F3 im Wesentlichen gleich (N1/N2)*F4 oder geringfügig kleiner ist.

5. Vorrichtung nach einem der Ansprüche 1 oder 2, **dadurch gekennzeichnet, dass** Nb die Werte der Folge N1 bis Np annimmt, wobei letztere einer nicht arithmetischen Progression folgen.

6. Vorrichtung nach Anspruch 5, **dadurch gekennzeichnet, dass** F3 im Wesentlichen gleich oder kleiner als aF4 ist, wobei a der kleinste Wert ist, der durch Teilung von zwei aufeinanderfolgenden Elementen der Folge N1, ... Np erhalten wird.

7. Vorrichtung nach Anspruch 5, **dadurch gekennzeichnet, dass**, wenn mehrere Regelungen es erlauben, die gleiche Ausgangsfrequenz zu erzeugen, die Regelung darin besteht, den höchsten Teilungsrang Nb zu wählen, um die Frequenz zu erzeugen.

8. Vorrichtung nach Anspruch 1, **dadurch gekennzeichnet, dass** jede der Längen des Zyklus der Steuerung N/N+1/N+2/ ... entsprechend jedem möglichen Wert von Nb das Produkt von Primzahlen miteinander ist.

9. Vorrichtung nach einem der Ansprüche 1 bis 8, **dadurch gekennzeichnet, dass** sie eine Mischstufe aufweist, die das Ausgangssignal vom Synthetisierer mit Fraktionalteilung und ein Mischsignal empfängt.

10. Verfahren zum Synthetisieren eines Signals in einem ersten Frequenzband F1-F2, das die folgenden Schritte aufweist:
• Synthetisieren eines Signals in einem zweiten Frequenzband F3-F4 mit Hilfe eines Frequenzsynthetisierers Phasenverriegelungsschleife, der einen Schleifenteiler mit variablem Rang Na(2) enthält,
• Teilen der Frequenz des Ausgangssignals des Synthetisierers durch einen variablen Rang Nb,
• Überwachen der Teilungsränge Na und Nb,
**dadurch gekennzeichnet, dass**
• die Synthese des Signals in einem zweiten Frequenzband eine Synthese mit Fraktionalteilung ist, wobei der Teilungsrang Na zyklisch variiert,
• die Länge des Variationszyklus von Na in Abhängigkeit von Nb variiert.

11. Verfahren nach Anspruch 10, **dadurch gekennzeichnet, dass** die Werte Nb gemäß einer arithmetischen Folge N1 ... Np variieren, und dass die Frequenz F4 gleich N1*F2 und die Frequenz F3 eine Funktion von N2 ist.

12. Verfahren nach Anspruch 11, **dadurch gekennzeichnet, dass** der Wert der Frequenz F3 im Wesentlichen gleich (N1/N2)*F4 oder geringfügig kleiner gewählt wird.

13. Verfahren nach Anspruch 10, **dadurch gekennzeichnet, dass** die Werte Nb gemäß einer nicht arithmetischen Folge variieren, und dass die erhaltenen Verhältnisse verglichen werden, indem zwei aufeinanderfolgende Elemente der Folge N1/N2, ... (Np-1)/Np geteilt werden.

14. Verfahren nach Anspruch 13, **dadurch gekennzeichnet, dass** F3 im Wesentlichen gleich oder kleiner als aF4 ist, wobei a der kleinste Wert ist, der durch Teilen von zwei aufeinanderfolgenden Elementen der Folge erhalten wird.

15. Verfahren nach Anspruch 14, **dadurch gekennzeichnet, dass**, wenn mehrere Regelungen es erlauben, die gleiche Ausgangsfrequenz zu erzeugen, die Regelung, die den höchsten Teilungsrang Nb aufweist, verwendet wird, um die Frequenz zu erzeugen.

16. Verfahren nach einem der Ansprüche 10 bis 15, **dadurch gekennzeichnet, dass** die Änderung der Teilungsränge gleichzeitig ist.

17. Verfahren nach einem der Ansprüche 10 bis 16, **dadurch gekennzeichnet, dass** das Verhältnis zwischen der Bezugsfrequenz des Synthetisierers mit variabler Teilung und der Frequenzteilung Fref/ΔF das kleinste gemeinsame Vielfache (kgV) der Folge N1 ... Np ist.
